(19) Europäisches Patentamt
European Patent Office
Office européen des brevets

(11) **EP 4 450 549 B1**

(12) **EUROPEAN PATENT SPECIFICATION**

(45) Date of publication and mention of the grant of the patent:
**10.12.2025 Bulletin 2025/50**

(21) Application number: **23839806.9**

(22) Date of filing: **07.06.2023**

(51) International Patent Classification (IPC):
***C08K 5/5415*** *(2006.01)* ***C08K 5/5419*** *(2006.01)*
***C08K 5/544*** *(2006.01)* ***C08K 5/00*** *(2006.01)*
***C08L 23/08*** *(2025.01)* ***C08J 5/18*** *(2006.01)*
***H10F 19/80*** *(2025.01)* ***C08K 5/14*** *(2006.01)*
***C08K 5/23*** *(2006.01)*

(52) Cooperative Patent Classification (CPC):
(C-Sets available)
**C08J 5/18; H10F 19/80; H10F 19/804;**
C08K 2201/014; C08L 23/0815; C08L 2203/206;
Y02E 10/50 (Cont.)

(86) International application number:
**PCT/KR2023/007768**

(87) International publication number:
**WO 2024/014712 (18.01.2024 Gazette 2024/03)**

(54) **ENCAPSULANT FILM COMPOSITION AND ENCAPSULANT FILM COMPRISING SAME**

VERKAPSELUNGSFOLIENZUSAMMENSETZUNG UND VERKAPSELUNGSFOLIE DAMIT

COMPOSITION DE FILM D'ENCAPSULATION ET FILM D'ENCAPSULATION LA COMPRENANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **11.07.2022 KR 20220085136**
**29.07.2022 KR 20220094551**

(43) Date of publication of application:
**23.10.2024 Bulletin 2024/43**

(73) Proprietor: **LG Chem, Ltd.**
**Yeongdeungpo-gu**
**Seoul 07336 (KR)**

(72) Inventors:
- **LEE, Young Woo**
  **Daejeon 34122 (KR)**
- **GONG, Jin Sam**
  **Daejeon 34122 (KR)**
- **PARK, Sang Eun**
  **Daejeon 34122 (KR)**
- **LEE, Si Jung**
  **Daejeon 34122 (KR)**
- **KIM, Jong Gil**
  **Daejeon 34122 (KR)**
- **LEE, Eun Jung**
  **Daejeon 34122 (KR)**

(74) Representative: **Hoffmann Eitle**
**Patent- und Rechtsanwälte PartmbB**
**Arabellastraße 30**
**81925 München (DE)**

(56) References cited:
**WO-A1-2019/000744**
**JP-A- 2009 173 773**
**JP-A- 2012 124 340**
**KR-A- 20130 039 950**
**KR-A- 20210 037 582**
**US-A1- 2017 211 019**
**US-A1- 2020 347 213**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08K 5/14, C08L 23/0815;**
**C08K 5/34924, C08L 23/0815;**
**C08K 5/5425, C08L 23/0815**

## Description

### TECHNICAL FIELD

The present invention relates to an encapsulant film composition, including an ethylene/alpha-olefin copolymer, an encapsulant film, and a solar cell module.

### BACKGROUND ART

As global environmental problems, energy problems, etc. are getting worse and worse, solar cells are attracting attention as a means of generating energy that is clean and has no risk of depletion. When the solar cells are used outdoors, such as the roof of a building, a module type thereof is generally used. In order to obtain a crystalline solar cell module when a solar cell module is manufactured, the solar cell module is manufactured by stacking a protective sheet for a solar cell module (transparent protective member on the surface side)/a solar cell encapsulant/a crystalline solar cell element/a solar cell encapsulant/a protective sheet for a solar cell module (protective member on the back side) in order. Meanwhile, in order to obtain a thin film-based solar cell module, a solar cell module is manufactured by stacking a thin film-type solar cell element/a solar cell encapsulant/a protective sheet for a solar cell module (protective member on the back side) in order.

As the aforementioned solar cell encapsulant, an ethylene/vinyl acetate copolymer, an ethylene/alpha-olefin copolymer, or the like is generally used. In addition, a light stabilizer is typically included as an additive in the solar cell encapsulant due to the requirement of long-term weather resistance. In addition, a silane coupling agent is typically included in the solar cell encapsulant in consideration of the adhesion of the transparent protective member on the surface side or the protective member on the back side, which is represented by glass.

Specifically, ethylene/vinyl acetate copolymer (EVA) sheets have been widely used because the transparency, flexibility, adhesiveness, and the like are excellent. Ethylene/vinyl acetate copolymer (EVA) membranes are being widely used because the transparency, flexibility, adhesiveness, and the like are excellent. However, if the EVA composition is used as a constituent material for the solar cell encapsulant, there is a concern that components such as acetic acid gas generated by the decomposition of EVA may have an adverse effect on the solar cell element.

The ethylene/alpha-olefin copolymer has no hydrolysis problem of a resin, and thus it is possible to solve the problem of the deterioration in life or reliability. However, since the ethylene/alpha-olefin copolymer does not include a polar group in the resin, the mixing properties with a polar crosslinking aid included as the constituent material of the solar cell encapsulant is deteriorated, and thus impregnation takes a very long time, so that there is a limitation in the productivity.

As such, there is a need to develop a crosslinking aid capable of improving the productivity of the solar cell encapsulant including the ethylene/alpha-olefin copolymer which has excellent volume resistivity and thus may be effectively utilized as a material requiring high insulation properties, such as a solar cell encapsulant.

[Prior Art Document]

[PATENT DOCUMENT]

(Patent Document 1) Korean Patent Laid-open Publication No. 2018-0063669. US 2020/347213 A1 and WO 2019/000744 A1 disclose a curable composition for forming an encapsulant film for a photovoltaic cell.

### DISCLOSURE OF THE INVENTION

### TECHNICAL PROBLEM

The purpose of the present invention is to provide a encapsulant film composition including a crosslinking aid having excellent mixing properties with an ethylene/alpha-olefin copolymer.

### TECHNICAL SOLUTION

In order to solve the above problem, the present invention provides an encapsulant film composition, an encapsulant film, and a solar cell module.

[1] The present invention provides an encapsulant film composition including an ethylene/alpha-olefin copolymer, a crosslinking agent, a crosslinking aid, and a silane coupling agent, wherein the crosslinking aid includes a compound represented by Formula 1 below:

[Formula 1]

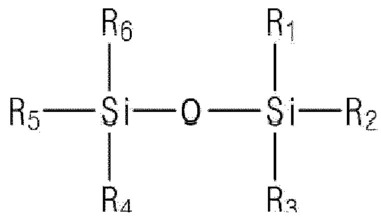

In Formula 1 above,
$R_1$ to $R_6$ are each independently alkyl having 1 to 20 carbon atoms or alkenyl having 2 to 20 carbon atoms, wherein at least two among $R_1$ to $R_3$ and at least two among $R_4$ to $R_6$ are each independently alkenyl having 2 to 20 carbon atoms.

[2] In [1] above of the present invention, there is provided the encapsulant film composition, wherein $R_1$, $R_3$, $R_4$, and $R_6$ above are each independently alkenyl having 2 to 20 carbon atoms, and $R_2$ and $R_5$ above are each independently alkyl having 1 to 20 carbon atoms or alkenyl having 2 to 20 carbon atoms.

[3] In [1] or [2] above of the present invention, there is provided the encapsulant film composition, wherein $R_1$, $R_3$, $R_4$, and $R_6$ above are each independently alkenyl having 2 to 12 carbon atoms and having a double bond in the end thereof, and $R_2$ and $R_5$ above are each independently alkyl having 1 to 12 carbon atoms or alkenyl having 2 to 12 carbon atoms and having a double bond in the end thereof.

[4] In any one of [1] to [3] above of the present invention, there is provided the encapsulant film composition, wherein the crosslinking aid compound of Formula 1 above is hexavinyl disiloxane or tetravinyldimethyl disiloxane.

[5] In any one of [1] to [4] above of the present invention, there is provided the encapsulant film composition, wherein the crosslinking aid further includes an allyl group-containing compound.

[6] In [5] above of the present invention, there is provided the encapsulant film composition, wherein the allyl group-containing compound includes at least one selected from the group consisting of triallyl isocyanurate, triallyl cyanurate, diallyl phthalate, diallyl fumarate, and diallyl maleate.

[7] In [5] or [6] above of the present invention, there is provided the encapsulant film composition, wherein the molar ratio of the compound represented by Formula 1 above to the allyl group-containing compound is 1:0.1 to 1:10.

[8] In any one of [1] to [7] above of the present invention, there is provided the encapsulant film composition, wherein the crosslinking aid is contained in an amount of 0.01 to 5 parts by weight based on 100 parts by weight of the encapsulant film composition.

[9] In any one of [1] to [8] above of the present invention, there is provided the encapsulant film composition further including at least one selected from the group consisting of an unsaturated silane compound, an aminosilane compound, a light stabilizer, a UV absorber, and a thermal stabilizer.

[10] The present invention provides an encapsulant film including the encapsulant film composition of any one of [1] to [9] above.

[11] The present invention provides a solar cell module including the encapsulant film of [10] above.

## ADVANTAGEOUS EFFECTS

The encapsulant film composition according to the present invention includes, as a crosslinking aid, a compound having excellent mixing properties with an ethylene/alpha-olefin copolymer, and is quickly impregnated in the ethylene/alpha-olefin copolymer, and an encapsulant film produced using the encapsulant film composition shows excellent volume resistivity and light transmittance, and thus can be widely used in the electrical and electronics industry.

## MODE FOR CARRYING OUT THE INVENTION

Hereinafter, the present invention will be described in more detail to aid in understanding the present invention.

Terms or words used in the specification and claims should not be interpreted as being limited to a conventional or dictionary meaning, and should be interpreted as the meaning and concept that accord with the technical spirit on the grounds of the principle that the inventor can appropriately define the concept of the term in order to explain invention in the best way.

**[Encapsulant Film Composition]**

An encapsulant film composition of the present invention includes (a) an ethylene/alpha-olefin copolymer, (b) a crosslinking agent, (c) a crosslinking aid, and (d) a silane coupling agent, wherein the crosslinking aid includes a compound represented by Formula 1.

[Formula 1]

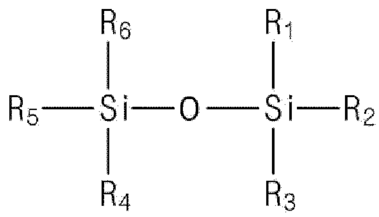

In Formula 1 above,
$R_1$ to $R_6$ are each independently alkyl having 1 to 20 carbon atoms or alkenyl having 2 to 20 carbon atoms, wherein at least two among $R_1$ to $R_3$ and at least two among $R_4$ to $R_6$ are each independently alkenyl having 2 to 20 carbon atoms.
Hereinafter, each component will be described in detail.

(a) Ethylene/alpha-olefin copolymer

The encapsulant film composition of the present invention includes an ethylene/alpha-olefin copolymer. The ethylene/alpha-olefin copolymer is prepared by copolymerizing ethylene and an alpha-olefin-based monomer, in which the alpha-olefin, which refers to a portion derived from the alpha-olefin-based monomer in the copolymer, may include alpha-olefin having 4 to 20 carbon atoms, specifically, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, or the like, and may be one alone or a mixture of two or more thereof.
Among these, the alpha-olefin may be 1-butene, 1-hexene, or 1-octene, and preferably may be 1-butene, 1-octene, or a combination thereof.
In addition, the content of the alpha-olefin in the ethylene/alpha-olefin copolymer may be appropriately selected within a range satisfying the above-described physical properties, and specifically, may be 0 to 99 mol% (exclusive of 0), and 10 to 50 mol%, but is not limited thereto.
In the present invention, a method for preparing an ethylene/alpha-olefin copolymer or an obtaining route thereof is not limited, and a person skilled in the art may select and use an appropriate one in consideration of the physical properties and purpose of an encapsulant film composition.

(b) Crosslinking agent

The encapsulant film composition of the present invention includes a crosslinking agent. The crosslinking agent is a radical initiator in the preparation step of the silane modified resin composition and may play the role of initiating the grafting reaction of the unsaturated silane compound into the resin composition. In addition, by forming a crosslinking bond in the silane modified resin composition or between the silane modified resin composition and an unmodified resin composition in the step of lamination during manufacturing an optoelectronic device, the heat resistance and durability of a final product, for example, an encapsulant sheet may be improved.
The crosslinking agent may use various crosslinking agents known in the art as long as it may be a crosslinking agent which may initiate the radical polymerization of a vinyl group or form a crosslinking bond, for example, one or two or more selected from the group consisting of an organic peroxide, a hydroperoxide and an azo compound may be used.
For example, the encapsulant for a solar cell may include organic peroxide as a crosslinking agent, and the organic peroxide serves to improve weather resistance of the encapsulant for a solar cell.
In particular, one or more selected from the group consisting of: dialkyl peroxides such as *t*-butylcumylperoxide, di-*t*-butyl peroxide, di-cumyl peroxide, 2,5-dimethyl-2,5-di(*t*-butylperoxy) hexane, and 2,5-dimethyl-2,5-di(*t*-butylperoxy)-3-hexyne; hydro peroxides such as cumene hydroperoxide, diisopropyl benzene hydro peroxide, 2,5-dimethyl-2,5-di(hydroperoxy)hexane, and t-butylhydroperoxide; diacyl peroxides such as bis-3,5,5-trimethylhexanoyl peroxide, octanoylperoxide, benzoyl peroxide, o-methylbenzoylperoxide, and 2,4-dichlorobenzoyl peroxide; peroxy esters such as *t*-butylperoxy iso butyrate, *t*-butylperoxy acetate, *t*-butylperoxy-2-ethylhexylcarbonate (TBEC), *t*-butylperoxy-2-ethylhexanoate, *t*-butylperoxy pivalate, *t*-butylperoxy octoate, *t*-butylperoxyisopropyl carbonate, *t*-butylperoxybenzoate, di*t*-butylperoxyphthalate, 2,5-dimethyl-2,5-di(benzoylperoxy)hexane, and 2,5-dimethyl-2,5-di(benzoylperoxy)-3-hexyne; ketone peroxides such as methyl ethyl ketone peroxide, and cyclohexanone peroxide, and azo compounds such as lauryl peroxide, azobisisobutyronitrile and azobis (2,4-dimethylvaleronitrile), may be included, but are not limited thereto.

The organic peroxide may be an organic peroxide having a one-hour half-life temperature of 120 °C to 135 °C, for example, 120 °C to 130 °C, 120 °C to 125 °C, preferably, 121 °C. The "one-hour half-life temperature" means a temperature at which the half-life of the crosslinking agent becomes one hour. According to the one-hour half-life temperature, the temperature at which the radical initiation reaction is efficiently carried out is changed, and accordingly, if an organic peroxide having the one-hour half-life temperature in the above-described range is used as the crosslinking agent, radical initiation reaction, that is, crosslinking reaction may be effectively performed at a lamination process temperature for manufacturing an optoelectronic device.

The crosslinking agent may be contained in an amount of 0.01 to 2 parts by weight, for example, 0.05 to 1.5 parts by weight, 0.1 to 1.5 parts by weight, or 0.5 to 1.5 parts by weight, based on 100 parts by weight of the ethylene/alpha-olefin copolymer. When the crosslinking agent is contained in the above range, an effect of improving heat resistance is sufficiently exhibited, and the moldability of the encapsulant film is also excellent, and thus a process restriction or a decrease in the physical properties of the encapsulant may not occur.

(c) Crosslinking aid

The encapsulant film composition of the present invention includes a crosslinking aid, wherein the crosslinking aid includes a compound represented by Formula 1 below and an allyl group-containing compound:

[Formula 1]

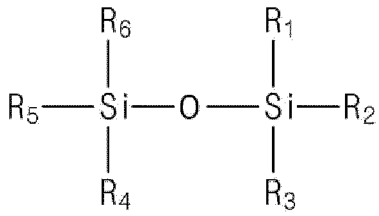

In Formula 1 above,
$R_1$ to $R_6$ are each independently alkyl having 1 to 20 carbon atoms or alkenyl having 2 to 20 carbon atoms, wherein at least two among $R_1$ to $R_3$ and at least two among $R_4$ to $R_6$ are each independently alkenyl having 2 to 20 carbon atoms.

In addition, in Formula 1 above, $R_1$, $R_3$, $R_4$, and $R_6$ above may be each independently alkenyl having 2 to 12 carbon atoms and having a double bond in the end thereof, and $R_2$ and $R_5$ above may be each independently alkyl having 1 to 12 carbon atoms or alkenyl having 2 to 12 carbon atoms and having a double bond in the end thereof.

In addition, the encapsulant film composition according to an example of the present invention is specifically a compound of Formula 1 above, and may include hexavinyl disiloxane represented by Formula 2 below, or tetravinyldimethyl disiloxane represented by Formula 3 below:

[Formula 2]

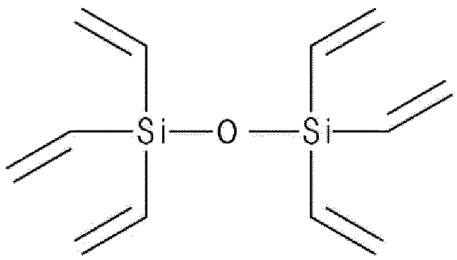

[Formula 3]

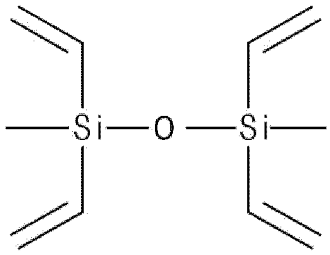

The allyl group-containing crosslinking agents, which are currently and widely used, include multiple polar functional groups, whereas the crosslinking aid used in the present invention is formed on only a non-polar functional group such as siloxane, and thus the impregnation rate of the ethylene/alpha-olefin copolymer, which is a non-polar material in the encapsulant film composition, may be improved.

The crosslinking aid used in the present invention has at least four double bonds, and thus sufficient number of double bonds to participate in the crosslinking reaction is secured, and if the double bonds are contained less than this, the crosslinking degree is reduced, it is practically impossible to use the encapsulant as a solar cell encapsulant.

By including the crosslinking aid in the encapsulant film composition, the crosslinking degree of the encapsulant film composition by the above-described crosslinking agent may be increased, and accordingly, the heat resistance and durability of a final product, for example, an encapsulant film may be even further improved.

In the present invention, the crosslinking aid may further include an allyl group-containing compound. By using the allyl group-containing compound in admixture together, the crosslinking degree may be further improved while the impregnation rate of the ethylene/alpha-olefin copolymer may be maintained high.

The allyl group-containing compound may include at least one selected from the group consisting of triallyl isocyanurate, triallyl cyanurate, diallyl phthalate, diallyl fumarate, and diallyl maleate.

Here, the molar ratio of the compound represented by Formula 1 above to the allyl group-containing compound may be 1:0.1 to 1:10, specifically, 1:2 to 1:5, and more specifically 1:0.3 to 1:4.

Within the above range, the crosslinking degree of the encapsulant film composition may also be improved while reducing the impregnation time of the ethylene/alpha-olefin copolymer.

In addition, the crosslinking aid may be contained in an amount of 0.01 to 5 parts by weight, particularly, 0.05 to 3 parts by weight, or 0.1 to 2 parts by weight based on 100 parts by weight of the encapsulant film composition.

The crosslinking aid is included in the above range, and thus the crosslinking aid impregnation time of the ethylene/alpha-olefin copolymer may be reduced while the crosslinking degree of the encapsulant film composition may be maintained high.

(d) Silane coupling agent

The encapsulant film composition of the present invention includes a silane coupling agent, which may serve to improve the adhesion between the encapsulant film and the solar cell.

As the silane coupling agent, for example, one or more selected from the group consisting of *N*-(β-aminoethyl)-γ-aminopropyltrimethoxysilane, *N*-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO) may be used, but the present invention is not limited thereto.

The silane coupling agent may be contained in an amount of 0.1 to 0.4 parts by weight based on 100 parts by weight of the encapsulant film composition. When the content of the silane coupling agent is within the above range, the solar cell module may have excellent adhesion to the glass, thereby preventing deterioration of long-term performance of the module due to the penetration of moisture.

In addition, the encapsulant film composition of the present invention may further include at least one selected from the group consisting of an unsaturated silane compound, an aminosilane compound, a light stabilizer, a UV absorber, and a thermal stabilizer.

The unsaturated silane compound may be grafted into a main chain including a polymerization unit of the monomer of the copolymer of the present invention in the presence of a radical initiator to be included in a polymerized state into a silane modified resin composition or an amino silane modified resin composition.

The unsaturated silane compound may be vinyltrimethoxy silane, vinyltriethoxy silane, vinyltripropoxy silane, vinyltriisopropoxy silane, vinyltributoxy silane, vinyltripentoxy silane, vinyltriphenoxy silane, vinyltriacetoxy silane, or the like, and in an embodiment, the vinyltrimethoxy silane or the vinyltriethoxy silane may be used among them, without

limitation.

In addition, the amino silane compound may further improve the adhesive strength with the back side sheet composed of top and bottom glass substrates or a fluorine resin, by acting as a catalyst promoting hydrolysis reaction transforming a reactive functional group such as an alkoxy group of an unsaturated silane compound, for example, vinyltriethoxy silane, which is grafted into the copolymer, into a hydroxyl group in the grafting modification step of an ethylene/alpha-olefin copolymer. At the same time, the amino silane compound participates directly in a copolymerization reaction as a reactant, and a moiety having an amine functional group in an amino silane modified resin composition may be provided.

The amino silane compound may be any silane compounds including an amine group as long as it is a primary amine and a secondary amine, without specific limitation. For example, as the amino silane compound, aminotrialkoxysilane, aminodialkoxysilane, etc., may be used, and the example thereof may include one or more selected from the group consisting of 3-aminopropyltrimethoxysilane (APTMS), 3-aminopropyltriethoxysilane (APTES), bis[(3-triethoxysilyl)propyl]amine, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine (DAS), aminoethylaminopropyltriethoxysilane, aminoethylaminopropylmethyldimethoxysilane, aminoethylaminopropylmethyldiethoxysilane, aminoethylaminomethyltriethoxysilane, aminoethylaminomethylmethyldiethoxysilane, diethylenetriaminopropyltrimethoxysilane, diethylenetriaminopropyltriethoxysilane, diethylenetriaminopropylmethyldimethoxysilane, diethyleneaminomethylmethyldiethoxysilane, (*N*-phenylamino)methyltrimethoxysilane, (*N*-phenylamino)methyltriethoxysilane, (*N*-phenylamino)methylmethyldimethoxysilane, (*N*-phenylamino)methylmethyldiethoxysilane, 3-(*N*-phenylamino)propyltrimethoxysilane, 3-(*N*-phenylamino)propyltriethoxysilane, 3-(*N*-phenylamino)propylmethyldimethoxysilane, 3-(*N*-phenylamino)propylmethyldiethoxysilane, and *N*-(*N*-butyl)-3-aminopropyltrimethoxysilane. The amino silane compounds may be used alone or as a mixture type.

The light stabilizer may capture an active species for initiating the photo-induced degradation of a resin according to the use of the composition applied to play a role in preventing photooxidation. The kind of the light stabilizer used is not specifically limited, for example, known compounds such as a hindered amine-based compound and a hindered piperidine-based compound may be used.

The UV absorber, according to the use of the composition, absorbs ultraviolet rays from the sunlight, etc. and transform into harmless thermal energy in a molecule, and may play the role of preventing the excitation of the active species for initiating the photo-induced degradation in the resin composition. Particular kinds of the UV absorber used is not specifically limited, but, for example, benzophenone-based, benzotriazole-based, acrylonitrile-based, metal complex-based, hindered amine-based, inorganic UV absorber such as ultrafine titanium oxide particles and ultrafine zinc oxide particles may be used alone, or a mixture of two or more thereof may be used.

In addition, examples of the thermal stabilizer may include a phosphor-based thermal stabilizer such as tris(2,4-di-*tert*-butylphenyl)phosphite, bis[2,4-bis(1,1-dimethylethyl)-6-methylphenyl]ethylester phosphorous acid, tetrakis(2,4-di-*tert*-butylphenyl)[1,1-biphenyl]-4,4'-diylbisphosphonate and bis(2,4-di-*tert*-butylphenyl)pentaerythritoldiphosphite; and a lactone-based thermal stabilizer such as a reaction product of 8-hydroxy-5,7-di-*tert*-butyl-furan-2-on and o-xylene, and one or two or more thereof may be used.

The contents of the light stabilizer, UV absorber, and thermal stabilizer are not specifically limited. That is, the content of the additive may be appropriately selected considering the use of the resin composition, the shape or density of the additive, etc., and generally, may be appropriately controlled in a range of 0.01 parts by weight to 5 parts by weight based on 100 parts by weight of the total solid content of the encapsulant film composition.

**[Encapsulant film]**

In addition, the present invention provides an encapsulant film including the encapsulant film composition.

The encapsulant film of the present invention may be produced by molding the encapsulant film composition into a film or a sheet shape. The molding method is not specifically limited, and may be produced by making a sheet or film through a common process, for example, a T die process or extrusion. For example, the production of the encapsulant film may be performed by an in situ process using an apparatus in which the preparation of a modified resin composition using the encapsulant film composition, and a process for making a film or a sheet are connected with each other.

The thickness of the encapsulant film may be controlled to about 10 μm to about 2,000 μm, or about 100 μm to about 1250 μm, considering the supporting efficiency and breaking possibility of a device in an optoelectronic device, the weight lightening or workability of the device, etc., and may be changed according to particular use.

**[Solar Cell module]**

In addition, the present invention provides a solar cell module including the encapsulant film. The solar cell module in the present invention may have a configuration in which gaps between solar cells disposed in series or in parallel are filled with the encapsulant film of the present invention, a glass surface is disposed on a surface hit by sunlight, and a

rear surface is protected by a back sheet, but the present invention is not limited thereto, and various types and forms of solar cell modules manufactured by including the encapsulant film in the art may all be applied to the present invention.

The glass surface may be formed using tempered glass in order to protect the solar cell from external impact and prevent damage, and using low iron tempered glass having a low iron content in order to prevent the reflection of sunlight and increase transmittance of sunlight, but the present invention is not limited thereto.

The back sheet is a weather-resistant film for protecting the rear surface of the solar cell module from the outside, and includes, for example, a fluorine-based resin sheet, a metal plate or metal foil such as aluminum, a cyclic olefin-based resin sheet, a polycarbonate-based resin sheet, a poly(meth) acrylic-based resin sheet, a polyamide-based resin sheet, a polyester-based resin sheet, a composite sheet obtained by laminating a weather-resistant film and a barrier film, but is not limited thereto.

In addition, the solar cell module of the present invention may be manufactured according to a method known in the art, except including the above-described encapsulant film.

The solar cell module of the present invention is manufactured using the encapsulant film having excellent volume resistivity, and the encapsulant film may prevent a current from being leaked to the outside of the solar cell module due to the movement of electrons in the solar cell module, and thus a potential induced degradation (PID) phenomenon in which insulation is deteriorated, the current is leaked, and the output of the module is rapidly reduced may be significantly suppressed.

## Examples

Hereinafter, the present invention will be described in more detail according to the examples. However, the following examples are intended to illustrate the present invention, and the scope of the present invention is not limited thereto.

### Example 1

Tetravinyldimethyl disiloxane (TVDMDS, manufactured by Gelest Inc.) was prepared as a crosslinking aid.

LUCENE™ LF675 (500 g), which is an ethylene/1-butene copolymer, from LG Chem was dried overnight by using a 40 °C convection oven. The density of the LUCENE™ LF675 as measured according to ASTM D1505 is 0.877 g/cm3 and the melting index (190°C, 2.16 Kg) as measured according to ASTM D1238 is 14.0 g/10 min. The bowl temperature of a viscometer (Haake Modular Torque Viscometer manufactured by Thermo Electron (Karlsruhe) GmbH) was set as 40 °C. After the ethylene/alpha olefin copolymer was added to a bowl, a crosslinking agent composition (1.00 phr (parts per hundred rubber) of t-butyl 1-(2-ethylhexyl) monoperoxycarbonate (TBEC, manufactured by Sigma Aldrich) as a crosslinking agent, 0.25 phr of tetravinyldimethyl disiloxane (TVDMDS) prepared above as a crosslinking aid, and 0.20 phr of methacryloxypropyltrimethoxysilane (MEMO manufactured by Shin-Etsu Chemical Co., Ltd.) as a silane coupling agent) were added using an electronic pipette. The impregnation was terminated when the torque value rapidly increased by observing a change in the torque value over time while stirring the mixture at 40 rpm at 40 °C, and the impregnation completion time of the crosslinking agent composition was measured.

Thereafter, the impregnated sample was press-molded at a low temperature (under the condition of an extruder barrel temperature of 90-100 °C) to the extent that high-temperature crosslinking did not occur using a micro extruder, the molded sample having an average thickness of 0.5 mm, thereby preparing a sheet-shaped encapsulant film.

### Example 2

The encapsulant film was prepared in the same manner as in Example 1, except that the amount of tetravinyldimethyl disiloxane (TVDMDS) added as a crosslinking aid was changed to 0.50 phr.

### Example 3

The encapsulant film was prepared in the same manner as in Example 1, except that the amount of tetravinyldimethyl disiloxane (TVDMDS) added as a crosslinking aid was changed to 1.00 phr.

### Example 4

The encapsulant film was prepared in the same manner as in Example 1, except that hexavinyl disiloxane (HVDS) was used instead of tetravinyldimethyl disiloxane (TVDMDS).

**Example 5**

The encapsulant film was prepared in the same manner as in Example 1, except that hexavinyl disiloxane (HVDS) was used instead of tetravinyldimethyl disiloxane (TVDMDS) and the added amount was changed to 0.50 phr.

**Example 6**

The encapsulant film was prepared in the same manner as in Example 1, except that hexavinyl disiloxane (HVDS) was used instead of tetravinyldimethyl disiloxane (TVDMDS) and the added amount was changed to 1.00 phr.

**Example 7**

The encapsulant film was prepared in the same manner as in Example 1, except that the amount of tetravinyldimethyl disiloxane (TVDMDS) added was changed to 0.125 phr, and 0.375 phr of triallyl isocyanurate (TAIC) was further added.

**Example 8**

The encapsulant film was prepared in the same manner as in Example 1, except that 0.25 phr of triallyl isocyanurate (TAIC) was further added.

**Example 9**

The encapsulant film was prepared in the same manner as in Example 1, except that the amount of tetravinyldimethyl disiloxane (TVDMDS) added was changed to 0.375 phr, and 0.125 phr of triallyl isocyanurate (TAIC) was further added.

**Example 10**

The encapsulant film was prepared in the same manner as in Example 1, except that 0.125 phr of hexavinyl disiloxane (HVDS) was added instead of tetravinyldimethyl disiloxane (TVDMDS), and 0.375 phr of triallyl isocyanurate (TAIC) was further added.

**Example 11**

The encapsulant film was prepared in the same manner as in Example 1, except that 0.25 phr of hexavinyl disiloxane (HVDS) was added instead of tetravinyldimethyl disiloxane (TVDMDS), and 0.25 phr of triallyl isocyanurate (TAIC) was further added.

**Example 12**

The encapsulant film was prepared in the same manner as in Example 1, except that 0.375 phr of hexavinyl disiloxane (HVDS) was added instead of tetravinyldimethyl disiloxane (TVDMDS), and 0.125 phr of triallyl isocyanurate (TAIC) was further added.

**Comparative Example 1**

The encapsulant film was prepared in the same manner as in Example 1, except that triallyl isocyanurate (TAIC) was used as a crosslinking aid instead of tetravinyldimethyl disiloxane (TVDMDS) and the added amount was changed to 0.50 phr.

**Comparative Example 2**

The encapsulant film was prepared in the same manner as in Example 1, except that 1,3-divinyltetramethyldisiloxane (DVTMDS) was used as a crosslinking aid instead of tetravinyldimethyl disiloxane (TVDMDS) and the added amount was changed to 0.50 phr.

The crosslinking compositions used in Examples 1 to 12 and Comparative Examples 1 and 2 are listed in Table 1 below.

[Table 1]

| | Crosslinking aid | | | | Total amount of crosslinking aid | Weight ratio |
|---|---|---|---|---|---|---|
| | TVDMDS (phr) | HVDS (phr) | DVTMDS (phr) | TAIC (phr) | (phr) | |
| Example 1 | 0.25 | - | - | - | 0.25 | - |
| Example 2 | 0.50 | - | - | - | 0.50 | - |
| Example 3 | 1.00 | - | - | - | 1.00 | - |
| Example 4 | - | 0.25 | - | - | 0.25 | - |
| Example 5 | - | 0.50 | - | - | 0.50 | - |
| Example 6 | - | 1.00 | - | - | 1.00 | - |
| Example 7 | 0.125 | - | - | 0.375 | 0.5 | 1:3 |
| Example 8 | 0.25 | - | - | 0.25 | 0.5 | 1:1 |
| Example 9 | 0.375 | - | - | 0.125 | 0.5 | 3:1 |
| Example 10 | - | 0.125 | - | 0.375 | 0.5 | 1:3 |
| Example 11 | - | 0.25 | - | 0.25 | 0.5 | 1:1 |
| Example 12 | - | 0.375 | - | 0.125 | 0.5 | 3:1 |
| Comparative Example 1 | - | - | - | 0.50 | 0.5 | - |
| Comparative Example 2 | - | - | 0.50 | - | 0.5 | - |

*TVDMDS: Tetravinyldimethyl disiloxane

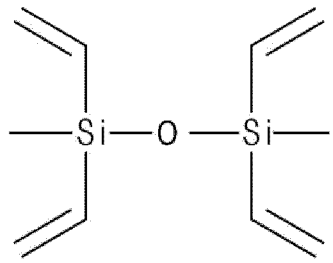

*HVDS: Hexavinyl disiloxane

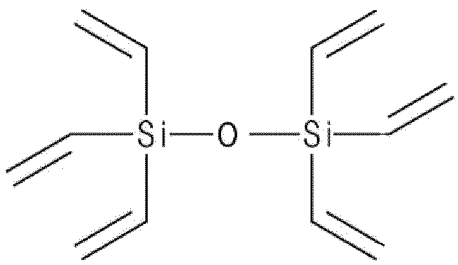

*TAIC: Triallyl isocyanurate

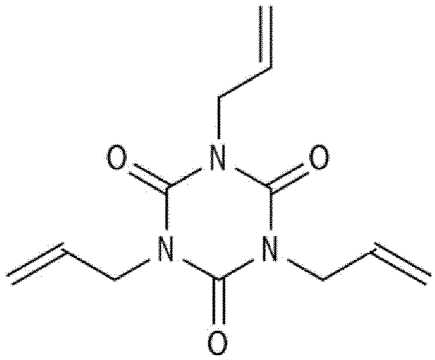

*DVTMDS: 1,3-divinyltetramethyl disiloxane

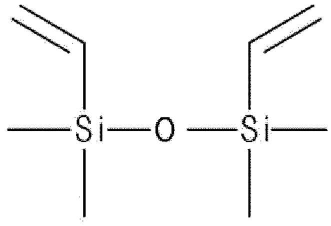

**Experimental Example 1**

An encapsulant film (15 cm × 15 cm) having a thickness of 0.5 mm prepared above was placed between two release films (thickness: about 100 μm), and laminated and crosslinked in a vacuum laminator for a process temperature of 150 °C and a process time of 20 minutes (vacuum 5 minutes/pressurizing 1 minute/pressure maintenance 14 minutes).

(1) Impregnation Completion Time

The crosslinking agent impregnation completion times as measured in Examples 1 to 12 and Comparative Examples 1 and 2 are listed in Table 2 below.

(2) Vulcanization Characteristics

According to ASTM D5289, the vulcanization characteristics were measured using premier MDR manufactured by Alpha Technologies. The test was carried out at 150 °C for 20 minutes and a torque curve was obtained over time. In this case, the 150 °C condition corresponds to a lamination temperature, and 20 minutes corresponds to a lamination time. In addition, the vulcanization characteristics between the samples were compared using the difference between the maximum torque (MH) and the minimum torque (ML) applied by MDR during such time. In addition, T90 (90% vulcanized time) was measured, and T90 means a vulcanization rate.

(3) Crosslinking degree

The crosslinked sheet was cut into a size of 3×3 $mm^2$ using scissors. The side and bottom of a 200-mesh wire mesh having a size of 7×10 $cm^2$ were blocked with staples. The sheet was injected into the wire mesh, and the weight of the injected sheet was measured. The amount of the sheet was 0.49 g to 0.51 g. When the sheet was added, the top of the wire mesh was blocked with staples and the total weight of the sample was measured. A solution in which 10 g of dibutylhydroxytoluene (BHT) was dissolved in 1,000 g of xylene was poured into a 2-L cylinder reactor, and 3 to 4 samples were added thereto. The reflux was terminated after 5 hours elapsed from the time when the reactor was heated and started to boil. The sample in the reactor was taken out with a metal scoop net and washed with xylene. The sample was dried in vacuum overnight at 100 °C. The weight of the dried sample was measured to calculate the crosslinking degree. The crosslinking degree may be determined as the average value of 3 to 4 samples refluxed in xylene.

Crosslinking degree (%) = [(weight of sheet after reflux)/(weight of sheet before reflux)]×100

[Table 2]

| | Impregnation completion time | Vulcanization characteristics | | Crosslinking degree |
|---|---|---|---|---|
| | (min) | $M_H$-$M_L$ (dNm) | T90 (min) | (%) |
| Example 1 | 5 | 3.12 | 12.91 | 70.5 |
| Example 2 | 7 | 3.33 | 12.32 | 72.0 |
| Example 3 | 8 | 4.35 | 11.12 | 76.7 |
| Example 4 | 7 | 3.24 | 12.10 | 71.6 |
| Example 5 | 7 | 3.67 | 11.36 | 72.7 |
| Example 6 | 9 | 4.44 | 10.44 | 77.0 |
| Example 7 | 34 | 3.68 | 12.55 | 77.8 |
| Example 8 | 18 | 3.63 | 12.41 | 76.6 |
| Example 9 | 10 | 3.56 | 12.18 | 75.6 |
| Example 10 | 33 | 3.86 | 12.37 | 76.8 |
| Example 11 | 24 | 3.72 | 12.01 | 76.2 |
| Example 12 | 11 | 3.63 | 11.77 | 75.1 |
| Comparative Example 1 | 60 | 3.68 | 13.00 | 77.5 |
| Comparative Example 2 | 9 | 1.69 | 13.52 | 39.0 |

As shown in Table 2, in the case of Examples 1 to 12 using the encapsulant film composition of the present invention, the impregnation completion time was reduced due to the fast impregnation rate and the crosslinking degree was also exhibited to be excellent.

On the other hand, it was confirmed that in the case of Comparative Example 1 using TAIC as the crosslinking aid, the impregnation completion time became far longer than those of Examples due to the slow impregnation rate, and in the case of Comparative Example 2 using the compound not corresponding to Formula 1 as the crosslinking aid, the crosslinking degree was deteriorated.

**Experimental Example 2**

(1) Volume Resistivity

The test was carried out at room temperature according to ASTM D257. The prepared sample was placed in the Keithley 8009 Resistivity test fixture, 1,000 V of voltage was applied to the 6517B Electrometer/High Resistance meter connected thereto, and then the volume resistivity was measured.

(2) Degree of Light Transmittance

A light transmittance at 200 nm to 1,000 nm was measured using the Shimadzu UV-3600 spectrophotometer to obtain a light transmittance curve, and then values at 280 nm to 380 nm and values at 380 nm to 1,100 nm were identified.

- Measurement mode: transmittance
- Wavelength interval: 1 nm
- Measurement speed: medium

(3) Measurement of Adhesive Strength

40% of the area of a glass substrate was covered with the encapsulant film, the remaining, 60% was covered with a polyimide film, and then a fluorine-based solar cell back sheet was laminated thereon. The lamination was performed at 150 °C for 20 minutes so that the encapsulant film was crosslinked and attached to the glass substrate. The encapsulant film of the specimen was cut into a width of 1 cm so that the width of the measurement portion became 1 cm.

A sample holder for UTM and 1 kN of load cell were mounted on a tensile compression tester (LRX Plus Universal Test Machine manufactured by Lloyd Instruments), and the end of the encapsulant film attached to the glass substrate and the end of a portion of the glass substrate to which the encapsulant film was not attached were fixed, respectively, and then pulled at 60 mm/min to test the adhesive strength.

[Table 3]

| | Volume resistivity ($\Omega\cdot$cm) | Degree of light transmittance (%T, 380-1,100 nm) | Adhesive strength (N/cm) |
|---|---|---|---|
| Example 1 | $3.9\times10^{16}$ | 92.2 | 206 |
| Example 2 | $4.1\times10^{16}$ | 92.3 | 211 |
| Example 3 | $4.3\times10^{16}$ | 92.3 | 215 |
| Example 4 | $5.6\times10^{16}$ | 92.4 | 206 |
| Example 5 | $1.0\times10^{17}$ | 92.4 | 215 |
| Example 6 | $8.8\times10^{16}$ | 92.3 | 216 |
| Example 7 | $1.8\times10^{16}$ | 92.2 | 210 |
| Example 8 | $1.9\times10^{16}$ | 92.1 | 212 |
| Example 9 | $2.0\times10^{16}$ | 92.2 | 208 |
| Example 10 | $6.5\times10^{16}$ | 92.4 | 202 |
| Example 11 | $6.4\times10^{16}$ | 92.4 | 204 |
| Example 12 | $6.4\times10^{16}$ | 92.3 | 211 |
| Comparative Example 1 | $2.9\times10^{16}$ | 92.3 | 212 |
| Comparative Example 2 | $3.8\times10^{16}$ | 92.2 | 212 |

As can be seen in Table 3 above, when the encapsulant film compositions of Examples 1 to 12 were used, it was confirmed that the volume resistivity, degree of light transmittance, and adhesive strength were also achieved at excellent levels.

## Claims

1. An encapsulant film composition comprising an ethylene/alpha-olefin copolymer, a crosslinking agent, a crosslinking aid, and a silane coupling agent, wherein the crosslinking aid comprises a compound represented by Formula 1 below:

[Formula 1]

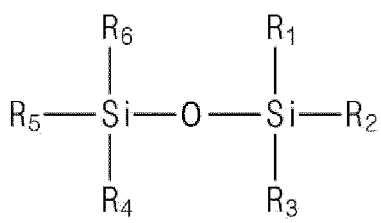

where, in Formula 1 above,
$R_1$ to $R_6$ are each independently alkyl having 1 to 20 carbon atoms or alkenyl having 2 to 20 carbon atoms, wherein at least two among $R_1$ to $R_3$ and at least two among $R_4$ to $R_6$ are each independently alkenyl having 2 to 20 carbon atoms.

2. The encapsulant film composition of claim 1, wherein $R_1$, $R_3$, $R_4$, and $R_6$ above are each independently alkenyl having 2 to 20 carbon atoms, and

$R_2$ and $R_5$ above are each independently alkyl having 1 to 20 carbon atoms or alkenyl having 2 to 20 carbon atoms.

3. The encapsulant film composition of claim 1, wherein $R_1$, $R_3$, $R_4$, and $R_6$ above are each independently alkenyl having 2 to 12 carbon atoms and having a double bond in the end thereof, and
$R_2$ and $R_5$ above are each independently alkyl having 1 to 12 carbon atoms or alkenyl having 2 to 12 carbon atoms and having a double bond in the end thereof.

4. The encapsulant film composition of claim 1, wherein the crosslinking aid compound of Formula 1 above is hexavinyl disiloxane or tetravinyldimethyl disiloxane.

5. The encapsulant film composition of claim 1, wherein the crosslinking aid further comprises an allyl group-containing compound.

6. The encapsulant film composition of claim 5, wherein the allyl group-containing compound comprises at least one selected from the group consisting of triallyl isocyanurate, triallyl cyanurate, diallyl phthalate, diallyl fumarate, and diallyl maleate.

7. The encapsulant film composition of claim 5, wherein the molar ratio of the compound represented by Formula 1 above to the allyl group-containing compound is 1:0.1 to 1:10.

8. The encapsulant film composition of claim 1, wherein the crosslinking aid is contained in an amount of 0.01 to 5 parts by weight based on 100 parts by weight of the encapsulant film composition.

9. The encapsulant film composition of claim 1, further comprising at least one selected from the group consisting of an unsaturated silane compound, an aminosilane compound, a light stabilizer, a UV absorber, and a thermal stabilizer.

10. An encapsulant film comprising the encapsulant film composition of any one of claims 1 to 9.

11. A solar cell module comprising the encapsulant film of claim 10.

**Patentansprüche**

1. Verkapselungsfilmzusammensetzung, die ein Ethylen/alpha-Olefin-Copolymer, ein Vernetzungsmittel, ein Vernetzungshilfsmittel und ein Silan-Haftvermittler umfasst, wobei das Vernetzungshilfsmittel eine Verbindung mit der folgenden Formel 1 umfasst:

[Formel 1]

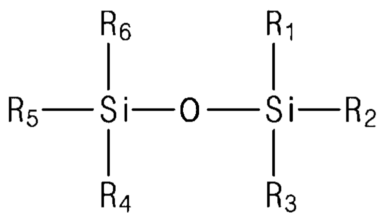

worin, in der obigen Formel 1,
$R_1$ bis $R_6$ jeweils unabhängig Alkyl mit 1 bis 20 Kohlenstoffatomen oder Alkenyl mit 2 bis 20 Kohlenstoffatomen sind, wobei mindestens zwei von $R_1$ bis $R_3$ und mindestens zwei von $R_4$ bis $R_6$ jeweils unabhängig Alkenyl mit 2 bis 20 Kohlenstoffatomen sind.

2. Verkapselungsfilmzusammensetzung nach Anspruch 1, wobei $R_1$, $R_3$, $R_4$ und $R_6$ jeweils unabhängig Alkenyl mit 2 bis 20 Kohlenstoffatomen sind, und
$R_2$ und $R_5$ jeweils unabhängig Alkyl mit 1 bis 20 Kohlenstoffatomen oder Alkenyl mit 2 bis 20 Kohlenstoffatomen sind.

3. Verkapselungsfilmzusammensetzung nach Anspruch 1, wobei $R_1$, $R_3$, $R_4$ und $R_6$ jeweils unabhängig Alkenyl mit 2 bis 12 Kohlenstoffatomen und einer Doppelbindung am Ende sind, und
$R_2$ und $R_5$ jeweils unabhängig Alkyl mit 1 bis 12 Kohlenstoffatomen oder Alkenyl mit 2 bis 12 Kohlenstoffatomen und einer Doppelbindung am Ende sind.

4. Verkapselungsfilmzusammensetzung nach Anspruch 1, wobei die Vernetzungshilfsmittel-Verbindung der obigen Formel 1 Hexavinyldisiloxan oder Tetravinyldimethyldisiloxan ist.

5. Verkapselungsfilmzusammensetzung nach Anspruch 1, wobei das Vernetzungshilfsmittel ferner eine Allylgruppen-haltige Verbindung umfasst.

6. Verkapselungsfilmzusammensetzung nach Anspruch 5, wobei die Allylgruppen-haltige Verbindung mindestens eine umfasst, ausgewählt aus der Gruppe bestehend aus Triallylisocyanurat, Triallylcyanurat, Diallylphthalat, Diallylfumarate und Diallylmaleate.

7. Verkapselungsfilmzusammensetzung nach Anspruch 5, wobei das Molverhältnis der durch die obige Formel 1 dargestellten Verbindung zu der Allylgruppen-haltigen Verbindung 1:0,1 bis 1:10 beträgt.

8. Verkapselungsfilmzusammensetzung nach Anspruch 1, wobei das Vernetzungshilfsmittel in einer Menge von 0,01 bis 5 Gewichtsteilen, bezogen auf 100 Gewichtsteile der Verkapselungsfilmzusammensetzung, enthalten ist.

9. Verkapselungsfilmzusammensetzung nach Anspruch 1, die ferner mindestens eines umfasst, ausgewählt aus der Gruppe bestehend aus einer ungesättigten Silanverbindung, einer Aminosilanverbindung, einem Lichtstabilisator, einem UV-Absorber und einem Wärmestabilisator.

10. Verkapselungsfilm, der die Verkapselungsfilmzusammensetzung nach mindestens einem der Ansprüche 1 bis 9 umfasst.

11. Solarzellenmodul, das den Verkapselungsfilm nach Anspruch 10 umfasst.

**Revendications**

1. Composition de film encapsulant comprenant un copolymère d'éthylène/alpha-oléfine, un agent de réticulation, un adjuvant de réticulation et un agent de couplage silane, dans laquelle l'adjuvant de réticulation comprend un composé représenté par la formule 1 ci-dessous :

[Formule 1]

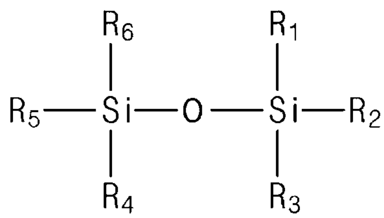

où, dans la formule 1 ci-dessus,
$R_1$ à $R_6$ sont chacun indépendamment un groupe alkyle ayant 1 à 20 atomes de carbone ou un groupe alcényle ayant 2 à 20 atomes de carbone, dans lequel au moins deux parmi $R_1$ à $R_3$ et au moins deux parmi $R_4$ à $R_6$ sont chacun indépendamment un groupe alcényle ayant 2 à 20 atomes de carbone.

2. La composition de film encapsulant selon la revendication 1, dans laquelle $R_1$, $R_3$, $R_4$ et $R_6$ ci-dessus sont chacun indépendamment un groupe alcényle ayant 2 à 20 atomes de carbone, et
$R_2$ et $R_5$ ci-dessus sont chacun indépendamment un groupe alkyle ayant 1 à 20 atomes de carbone ou un groupe alcényle ayant 2 à 20 atomes de carbone.

3. La composition de film encapsulant selon la revendication 1, dans laquelle $R_1$, $R_3$, $R_4$ et $R_6$ ci-dessus sont chacun indépendamment un groupe alcényle ayant 2 à 12 atomes de carbone et ayant une double liaison à son extrémité, et $R_2$ et $R_5$ ci-dessus sont chacun indépendamment un groupe alkyle ayant 1 à 12 atomes de carbone ou un groupe alcényle ayant 2 à 12 atomes de carbone et ayant une double liaison à son extrémité.

4. La composition de film encapsulant selon la revendication 1, dans laquelle le composé auxiliaire de réticulation de formule 1 ci-dessus est l'hexavinyl disiloxane ou le tétravinyldiméthyl disiloxane.

5. La composition de film encapsulant selon la revendication 1, dans laquelle l'auxiliaire de réticulation comprend en outre un composé contenant un groupe allyle.

6. La composition de film encapsulant selon la revendication 5, dans laquelle le composé contenant un groupe allyle comprend au moins un composé choisi dans le groupe constitué par l'isocyanurate de triallyle, le cyanurate de triallyle, le phtalate de diallyle, le fumarate de diallyle et le maléate de diallyle.

7. La composition de film encapsulant selon la revendication 5, dans laquelle le rapport molaire du composé représenté par la formule 1 ci-dessus au composé contenant un groupe allyle est de 1:0,1 à 1:10.

8. La composition de film encapsulant selon la revendication 1, dans laquelle l'adjuvant de réticulation est contenu en une quantité de 0,01 à 5 parties en poids pour 100 parties en poids de la composition de film encapsulant.

9. La composition de film encapsulant selon la revendication 1, comprenant en outre au moins un élément choisi dans le groupe constitué d'un composé silane insaturé, d'un composé aminosilane, d'un stabilisateur de lumière, d'un absorbeur d'UV et d'un stabilisateur thermique.

10. Film encapsulant comprenant la composition de film encapsulant selon l'une quelconque des revendications 1 à 9.

11. Module de cellules solaires comprenant le film encapsulant selon la revendication 10.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 20180063669
- US 2020347213 A1
- WO 2019000744 A1